Europäisches Patentamt

European Patent Office

Office européen des brevets

(11) Publication number: **0 042 473**

**A1**

(12) # EUROPEAN PATENT APPLICATION

(21) Application number: **81102418.1**

(22) Date of filing: **31.03.81**

(51) Int. Cl.³: **G 11 C 19/08**

(30) Priority: **18.06.80 US 160511**

(43) Date of publication of application:
**30.12.81 Bulletin 81/52**

(84) Designated Contracting States:
**DE FR GB IT**

(71) Applicant: **International Business Machines Corporation**

**Armonk, N.Y. 10504(US)**

(72) Inventor: **Scranton, Robert Alan
Spring Valley Road
Ossining New York 10562(US)**

(74) Representative: **Petersen, Richard Courtenay
IBM United Kingdom Patent Operations Hursley Park
Winchester Hants. SO21 2JN(GB)**

(54) Method and device for neel wall segment polarity detection in a cross-tie memory system.

(57) A method and device for detecting polarity of a Neel wall segment in a cross-tie memory system (10) involves applying a magnetic field of a given polarity to a Neel wall segment (18B) of unknown polarity so that the Neel wall segment expands into a transverse domain (22), if the magnetic field is applied in the same direction. The presence or absence of the transverse domain is then sensed with a magnetoresistive detector (24), located to one side of the Neel wall (18B) of unknown polarity segment.

FIG.3

EP 0 042 473 A1

Croydon Printing Company Ltd.

# METHOD AND DEVICE FOR NEEL WALL SEGMENT POLARITY DETECTION IN A CROSS-TIE MEMORY SYSTEM

This invention relates to a method and device for detecting the polarity of a Neel wall segment in a cross-tie system.

Cross-tie memories are described in US 3,868,659 and in the Schwee et al "Naval Ordinance Laboratory Technical Report", 74-176 October 1, 1974. In a cross-tie memory, information is stored in magnetic domain walls as Neel wall segments. The magnetic domain wall is located between two adjacent anti-parallel, that is, opposite polarity, domains. The cross-tie memory is in a thin magnetic film of a material, such as permalloy.

It is reported that an optical method of detection based on the Kerr rotation of polarized light reflected from the permalloy film is superior to the two known magneto-resistive detection techniques. One magneto-resistive sensing method is described in US 3,868,660 which describes the use of a probe means above the domain wall and the use of a localized magnetic field to cause the domain wall to undergo wall reversal motion which is subsequently sensed. This method is not considered to be suitable because the noise caused by propagation pulses interferes with the signal to be sensed. Another detection scheme is described in US 3,868,660 which describes the use of a probe means above the domain wall and the use of a localized magnetic field to cause the domain wall to undergo wall reversal motion which is subsequently sensed. This method is not considered to be suitable because
the noise caused by propagation pulses interferes with the
signal to be sensed. Another detection scheme is described
in US 3,846,770 in which a magnetic field is applied across
the width of the strip causing several reversal domains
collapse and utilizing conductor means for sensing the
remaining reversal domains.

According to the invention, a method for detecting the
polarity of a Neel wall segment in a cross-tie memory system,
comprises the steps of applying a magnetic field to a Neel
wall segment in a direction substantially the same or
opposite to the direction of magnetisation of the Neel wall
segment, so as to cause the Neel wall segment to expand into
a transverse domain, if the magnetisation direction is the
same, and sensing the presence or absence of the transverse
domain.

The invention extends to a device for detecting the
polarity of a Neel wall segment in a cross-tie memory system,
comprising means for applying a magnetic field to a Neel wall
segment to expand the Neel wall segment into a transverse
domain, in a direction substantially the same or opposite to
the direction of magnetisation of the Neel wall segment, if
the magnetisation direction is the same, and sensing means
for detecting the presence or absence of the transverse
domain.

The scope of the invention is defined by the appended
claims; and how it can be carried into effect is hereinafter
particularly described with reference to the accompanying
drawings, in which :

FIGURE 1 is a schematic diagram of part of a cross-tie memory to which the invention is applicable;

FIGURE 2 is a similar schematic view illustrating the first step of the method according to this invention; and

FIGURE 3 is a similar schematic view illustrating the second step of the method, and the device, according to this invention.

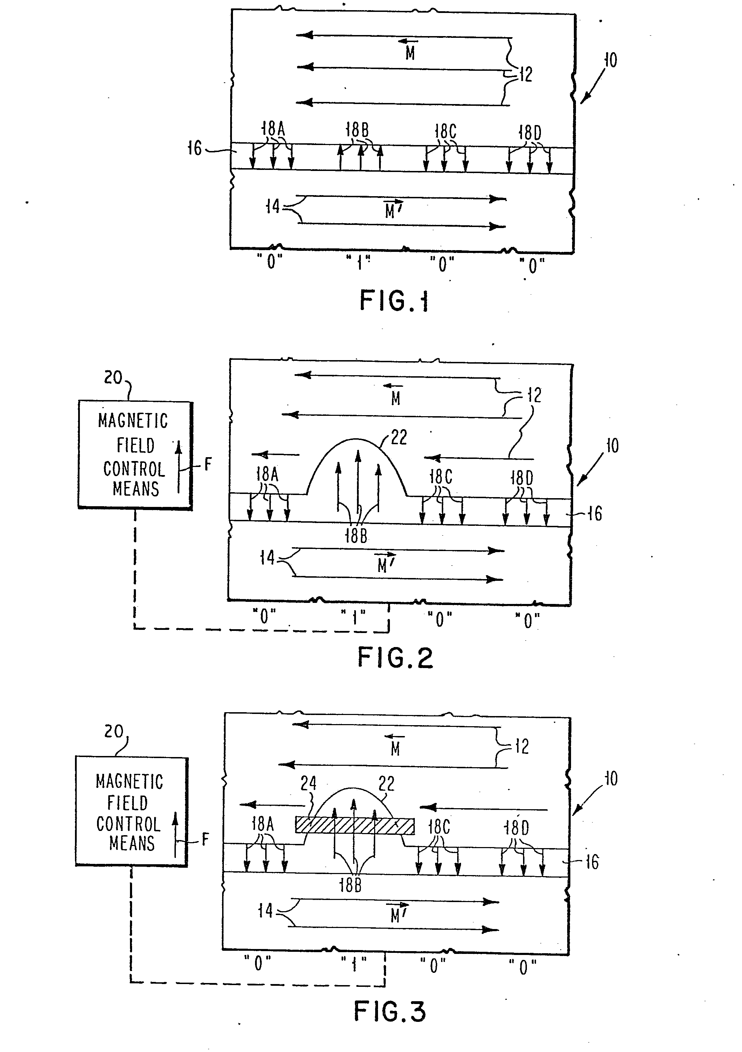

A cross-tie memory 10 (Fig.1) consists of a magnetic domain 12 having a magnetization direction M pointed to the left and a magnetic domain 14 with a magnetization direction M$'$ pointing to the right. The memory is in a magnetic film capable of supporting transverse domains, such as (100) oriented garnet films with four-fold in-plane anisotropy. Positioned between the domains 12 and 14 is a domain wall 16 containing Neel wall segments 18A, 18B, 18C and 18D whose polarity and magnetization is in one of two opposite directions normal to the magnetization directions of the domains in the middle of the segments. Neel wall segments 18A to 18D are separated by Bloch lines and cross-ties (not shown). Digital information in the cross-tie memory 10 is represented by the polarity for the direction of the Neel wall segments. For example, Neel wall segments 18A, 18C and 18D have the same polarity and their magnetization direction is pointed downward. These Neel wall segments 18A, 18C and 18D are designated as "zero" bits of information. Neel wall segment 18B, on the other hand, is of opposite polarity, that is, its magnetization is pointed in the opposite direction and represents a "one" bit of information.

In accordance with this embodiment of the invention
(Fig.2), a magnetic field control means 20 is activated to
apply a magnetic field to one Neel wall segment of cross-tie
memory 10 at right angles to the domain wall 16 and in a
direction F which is the same as the Neel wall segment 18B
causes the latter to expand into the domain 12 to form a
transverse domain 22.  If the magnetic field is applied to
one of the Neel wall segments 18A, 18C and 18D, which have a
polarity in the opposite direction to the Neel wall segment
and the applied magnetic field, no transverse domain is
formed.

A magnetoresistive sensor 24 (Fig.3) is positioned over
one of the domains, in this case domain 12, adjacent the
domain wall 16 where a transverse domain, in this case
transverse domain 22, would be formed if the local Neel wall
segment, in this case segment 18B, has a magnetization in the
same direction as the applied field F.  The magnetoresistive
sensor 24 is one such as is described in US 3,691,540, DE
2,148,081, FR 2,116,362 and GB 1,334,603.  The
magnetoresistive sensor 24 is connected to control means (not
shown), and detects or senses the presence of the transverse
domain 22.  Thus the polarity of the local Neel wall segment,
which was previously unknown, can be determined.

The disclosed method and device for detecting polarity
of a Neel wall segment in a cross-tie memory system involves
applying a magnetic field of a given polarity to a Neel wall
segment having an unknown polarity.  If the magnetic field is
applied in the same direction as the particular Neel wall
segment, then the Neel wall segment expands into a transverse
domain.  The transverse domain thus formed is then sensed
with a magnetoresistive detector.

YO9-79-091                          5

CLAIMS

1    A method for detecting the polarity of a Neel wall segment in a cross-tie memory system, comprising the steps of applying a magnetic field to a Neel wall segment in a direction substantially the same or opposite to the direction of magnetization of the Neel wall segment, so as to cause the Neel wall segment to expand into a transverse domain, if the magnetization direction is the same, and sensing the presence or absence of the transverse domain.

2    A method according to Claim 1, in which the transverse domain is sensed with a magnetoresistive detector.

3    A method according to claim 1 or 2, in which sensing is effected to one side of the Neel wall segment.

4    A device for detecting the polarity of a Neel wall segment in a cross-tie memory system, comprising:  means for applying a magnetic field to a Neel wall segment (18B) in a direction substantially the same or opposite to the direction of magnetization of the Neel wall segment, to expand the Neel wall segment into a transverse domain (22), if the magnetization direction is the same, and sensing means (24) for detecting the presence or absence of the transverse domain.

5    A device according to Claim 4, in which the sensing means is a magnetoresistive detector.

6    A device according to claim 4 or 5, in which the sensing means is located to one side of the Neel wall segment.

FIG.1

FIG.2

FIG.3

**European Patent Office**

**EUROPEAN SEARCH REPORT**

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| | US – A – 4 024 516 (SPERRY RAND CORPORATION)<br><br>* column 2, line 17 to column 4, line 36; figures 1-5 * | 1,3,4,6 | G 11 C 19/08 |
| A | GB – A – 1 443 345 (TECSI)<br><br>* page 2, lines 43-95; figures 1-3 * | 1 | |

| TECHNICAL FIELDS SEARCHED (Int. Cl.³) |
|---|
| G 11 C 19/08 |

| CATEGORY OF CITED DOCUMENTS |
|---|
| X: particularly relevant |
| A: technological background |
| O: non-written disclosure |
| P: intermediate document |
| T: theory or principle underlying the invention |
| E: conflicting application |
| D: document cited in the application |
| L: citation for other reasons |
| &: member of the same patent family, corresponding document |

The present search report has been drawn up for all claims

| Place of search | Date of completion of the search | Examiner |
|---|---|---|
| The Hague | 30-09-1981 | DEGRAEVE |

EPO Form 1503.1   06.78